# EUROPÄISCHE PATENTANMELDUNG

(11) **EP 4 024 621 A1**
(43) Veröffentlichungstag der Anmeldung: **06.07.2022**
(21) Anmeldenummer: 21150002.0
(22) Anmeldetag: 01.01.2021
(51) Int. Cl.: H01R 12/72, H01R 13/502, H01R 12/70, H01R 12/58

(54) **RUCKSACK FÜR EINEN STECKVERBINDER**

(71) Anmelder: Rosenberger Hochfrequenztechnik GmbH & Co. KG, 84526 Tittmoning (DE)
(72) Erfinder: Zebhauser, Martin, 83410 Laufen (DE); Löffelholz, Stefan, 64653 Lorsch (DE); Lochner, Georg Christoph, 84529 Tittmoning (DE)
(74) Vertreter: Warneke, Nicola

(57) **Zusammenfassung**

Leiterplattenanordnung (10) mit einer Leiterplatte (12), einem Leiterplattensteckverbinder (14), der auf der Leiterplatte vormontiert oder montiert ist und mit einem Gewicht (16), welches zumindest an dem Leiterplattensteckverbinder (14) angebracht ist, wobei der Leiterplattensteckverbinder (14) für sich genommen, in einer montierten Lage einen in die Leiterplattenebene (102) projizierten Schwerpunkt (104) aufweist, welcher sich außerhalb der Leiterplatte (12) befindet, und wobei ein Verbund (11) aus dem Leiterplattensteckverbinder (14) und dem Gewicht (16) in einer montierten Lage einen in die Leiterplattenebene (102) projizierten Schwerpunkt (106) aufweist, welche zu der Leiterplatte (12) einen geringeren Abstand oder keinen Abstand aufweist als der projizierte Schwerpunkt (104) des Leiterplattensteckverbinders (14).

## Beschreibung

### GEBIET DER ERFINDUNG

Die vorliegende Erfindung betrifft eine Leiterplattenanordnung.

### TECHNISCHER HINTERGRUND

Es ist bekannt, Steckverbinder auf Leiterplatten im Rahmen einer Vormontage zu fixieren, um einen Steckverbinder gegen ein Verkippen auf der Leiterplatte zu sichern. Hierdurch entsteht zusätzlicher Montageaufwand bzw. ist zusätzlicher Bauraum für vorgesehene Fixiermittel erforderlich.

Dies ist ein Zustand, den es zu verbessern gilt.

### ZUSAMMENFASSUNG DER ERFINDUNG

Erfindungsgemäß wird diese Aufgabe durch eine Leiterplattenanordnung mit den Merkmalen des Patentanspruchs 1 gelöst.

Demgemäß ist vorgesehen:
Eine Leiterplattenanordnung mit einer Leiterplatte, einem Leiterplattensteckverbinder, der auf der Leiterplatte vormontiert oder montiert ist und mit einem Gewicht, welches zumindest an dem Leiterplattensteckverbinder angebracht ist, wobei der Leiterplattensteckverbinder für sich genommen, in einer montierten Lage einen in die Leiterplattenebene projizierten Schwerpunkt aufweist, welcher sich außerhalb der Leiterplatte befindet, und wobei ein Verbund aus dem Leiterplattensteckverbinder und dem Gewicht in einer montierten Lage einen in die Leiterplattenebene projizierten Schwerpunkt aufweist, welche zu der Leiterplatte einen geringeren Abstand oder keinen Abstand aufweist als der projizierte Schwerpunkt des Leiterplattensteckverbinders.

Der Erfindung liegt die Erkenntnis zugrunde, dass Leiterplattensteckverbinder, die auf einer Leiterplatte zu montieren sind, häufig einen ungünstigen Schwerpunkt bezüglich der Lage der Leiterplatte aufweisen. So kommt es zu einem Verkippen des Leiterplattensteckverbinders gegenüber der Leiterplatte, wenn sich ein in die Leiterplattenebene projizierter Schwerpunkt des Leiterplattensteckverbinders sich außerhalb der Leiterplatte befindet.

Die Leiterplattenebene ist jene Ebene, die von der Leiterplatte aufgespannt wird bzw. die Ebene, die die Oberfläche einer Leiterplatte enthält.

Vormontierter Zustand bedeutet, dass die Steckverbinderanordnung lediglich teilweise montiert ist. Beispielsweise kann vorgesehen sein, dass Bauteile in einem vormontierten Zustand lösbar miteinander versteckt, jedoch noch nicht endgültig aneinander befestigt sind. Endmontierter Zustand bedeutet, dass die Montage der Steckverbinderanordnung abgeschlossen ist und die Steckverbinderanordnung zum Gebrauch bereitsteht.

In dieser Patentanmeldung ist zwischen dem Schwerpunkt und dem projizierten Schwerpunkt zu unterscheiden. Der Schwerpunkt eines Körpers ist das mit der Masse gewichtete Mittel der Positionen seiner Massepunkte. Für Gegenstände, die auf einer Leiterplatte montiert sind, befindet sich deren Schwerpunkt i.d.R. oberhalb der Leiterplatte. Ein projizierter Schwerpunkt ergibt sich durch eine senkrechte Projektion des Schwerpunkts in die Leiterplattenebene, wobei die Gerade zwischen Schwerpunkt und projizierten Schwerpunkt mit der Leiterplattenebene einen rechten Winkel einschließen.

Das Verkippen des Leiterplattensteckverbinders gegenüber der Leiterplatte führt häufig zu einer Beschädigung der elektrischen Kontakte des Leiterplattensteckverbinders und/oder der Leiterplatte.

Der Erfindung liegt die Idee zugrunde, den projizierten Schwerpunkt des Leiterplattensteckverbinders zur Leiterplatte hin zu verlagern, sodass ein Verkippen des Leiterplattensteckverbinders gegenüber der Leiterplatte vor einer Befestigung des Leiterplattensteckverbinders an der Leiterplatte verhindert wird.

Die Erfindung sieht vor, den Leiterplattensteckverbinder mit einem Gewicht zur Verlagerung des Schwerpunkts zu verbinden, bevor der Leiterplattensteckverbinder an der Leiterplatte vormontiert wird bzw. bevor die elektrischen Kontakte des Steckverbinders mit elektrischen Kontakten der Leiterplatte kontaktiert werden. Im Folgenden wird ein Leiterplattensteckverbinder, an dem ein Gewicht befestigt ist, auch als Verbund bezeichnet.

Es versteht sich, dass der in die Leiterplattenebene projizierte Schwerpunkt des Verbunds aus Gewicht und Leiterplattensteckverbinder bevorzugt möglichst nahe an bzw. innerhalb der Leiterplatte angeordnet ist und dass andererseits das Gewicht, mittels welchem der projizierte Schwerpunkt verlagert wird, möglichst gering und kompakt ausgebildet sein kann.

Um diesen Kompromiss in der Praxis abzubilden, kann es auch vorteilhaft sein, Haftkräfte und/oder Reibungskräfte zwischen dem Verbund und der Leiterplatte zu berücksichtigen. Das bedeutet, dass ein projizierter Schwerpunkt nicht zwangsläufig innerhalb der Leiterplatte liegen muss, um ein Verkippen des Verbunds aus Gewicht und Leiterplattensteckverbinder gegenüber der Leiterplatte zu verhindern, wenn die Haft- und Reibungskräfte zwischen dem Verbund und der Leiterplatte, auch in einem vormontierten Zustand ausreichend groß sind.

Die Lage des projizierten Schwerpunkts eines auf einer Leiterplatte vormontierten Leiterplattensteckverbinders kann bezüglich der Leiterplatte durch Rechnung, durch Simulation oder durch Versuche ermittelt bzw. geschätzt werden. Gleiches gilt für den Verbund aus dem Leiterplattensteckverbinder und dem Gewicht.

Vorteilhafte Ausgestaltungen und Weiterbildungen ergeben sich aus den weiteren Unteransprüchen sowie aus der Beschreibung unter Bezugnahme auf die Figuren der Zeichnung.

Gemäß einer bevorzugten Weiterbildung der Erfindung berührt das Gewicht die Leiterplatte. Dabei kann vorgesehen sein, dass das Gewicht an der Leiterplatte befestigt ist. Als Befestigungsmittel kommen z.B. Klebeverbindungen, Press-fit-Verbindungen und dergleichen in Betracht. Dies gewährleistet eine ausreichende Stabilisierung des Verbunds aus Gewicht und Leiterplattensteckverbinder gegenüber der Leiterplatte.

Gemäß einer bevorzugten Weiterbildung der Erfindung ist das Gewicht derart von der Leiterplatte abgestützt, dass zwischen der Leiterplatte und dem Leiterplattensteckverbinder ein Spalt existiert.

Somit ist es möglich, einem Verkanten des Leiterplattensteckverbinders gegenüber der Leiterplatte, beispielsweise aufgrund von Fertigungstoleranzen, vorzubeugen.

Es versteht sich, dass der Spalt zwischen der Leiterplatte und dem Leiterplattensteckverbinder partiell ausgebildet sein kann, das heißt, dass es ausreichend sein kann, wenn ein Spalt in einem Teilbereich eines Leiterplattensteckverbinders zwischen dem Leiterplattensteckverbinder und der Leiterplatte existiert. Ferner versteht es sich, dass der Spalt die Kontaktierung von elektrischen Kontakten der Leiterplatte und des Leiterplattensteckverbinders nicht beeinträchtigt, d.h. der Spalt erstreckt sich nicht auf die elektrischen Kontakte.

Gemäß einer bevorzugten Weiterbildung der Erfindung weist das Gewicht ein Kodiermittel zum Vorgeben einer oder mehrerer Montagepositionen und/oder Orientierungen des Leiterplattensteckverbinders auf der Leiterplatte auf. Somit kann eine falsche Montage des Leiterplattensteckverbinders verhindert werden, wenn die Kodiermittel derart ausgebildet sind, dass eine seitenverkehrte Montage des Leiterplattensteckverbinders auf der Leiterplatte verhindert wird. Gemäß einer bevorzugten Weiterbildung der Erfindung gewährleistet das Gewicht lediglich passive oder keine elektrischen Funktionalitäten der Leiterplattenanordnung. Somit ist die Modularität des Gewichts gewährleistet, das bedeutet, dass die Verwendung des Gewichts, nicht zwingend erforderlich ist, wenn Montageschwierigkeiten auch anderweitig behoben werden können.

Passive elektrische Eigenschaften sind sämtliche elektrischen Eigenschaften, die elektrisch leitenden Bauteilen inhärent sind, beispielsweise kann es sich ergeben, dass ein elektrisch leitendes Gewicht die elektromagnetische Schirmung eines Verbunds aus Gewicht und Leiterplattensteckverbinder verbessert.

Sämtliche Einflüsse des Gewichts auf elektrische Eigenschaften des Steckverbinders, wie dessen Schirmung oder Impedanz, werden als passive Eigenschaften bezeichnet, sofern diese nicht aktiv gesteuert werden müssen und sich aus dessen Material, Struktur und dergleichen ergeben.

Gemäß einer bevorzugten Weiterbildung der Erfindung sind einander berührende Komponenten des Leiterplattensteckverbinders und des Gewichts, mittels verschiedenen Fertigungsverfahren hergestellt. Dabei kann vorgesehen sein, dass eine Komponente des Leiterplattensteckverbinders, die das Gewicht berührt, mittels eines Stanz-Biege-Verfahrens hergestellt ist und das Gewicht mittels eines Guss-Verfahrens, beispielsweise mittels eines Druckgussverfahrens, hergestellt ist.

Beispielsweise ergibt es sich häufig, dass es vorteilhaft ist, einen Außenleiter eines Leiterplattensteckverbinders mittels eines Stanz-Biege-Verfahrens herzustellen, da somit eine große Bandbreite von Geometrien kostengünstig herstellbar ist. Allerdings kann es sich als nachteilig erweisen, Werkstücke mit einer hohen Masse mittels eines Stanz-Biege-Verfahrens zu verarbeiten. Beispielsweise erweist es sich in der Praxis häufig als vorteilhaft, Gegenstände mit einem hohen Gewicht mittels eines Gussverfahrens herzustellen.

Gemäß einer bevorzugten Weiterbildung der Erfindung ist der Leiterplattensteckverbinder irreversibel mit dem Gewicht verbunden. Irreversibel verbunden bedeutet, dass eine Verbindung zwischen zwei Gegenständen nicht zerstörungsfrei bzw. beschädigungsfrei lösbar ist, es sei denn eine Verbindung ist gezielt zur Zerstörung vorgesehen, und/oder dass die zu verbindenden Komponenten im Rahmen des Verbindungsprozesses verformt wurden.

Als irreversible Verbindungen kommen stoffschlüssige Verbindungen, wie beispielsweise Löten oder Kleben, formschlüssige Verbindungen, kraftschlüssige Verbindungen, z.B. Verspannen, in Betracht. Insbesondere ist es denkbar, dass Gewicht mittels eines Durchsetzfügeprozesses, z.B. Clinchen, an dem Leiterplattensteckverbinder zu befestigen. Auch beständige Rast- oder Schnappverbindungen sind für eine irreversible Verbindung zwischen dem Leiterplattensteckverbinder und dem Gewicht möglich.

Alternativ ist es auch denkbar, das Gewicht lösbar an dem Leiterplattensteckverbinder zu befestigen. Dabei kann auch vorgesehen sein, dass das Gewicht von dem Leiterplattensteckverbinder entfernt wird, nachdem die Montage des Leiterplattensteckverbinders auf der Leiterplatte abgeschlossen ist.

Beispielsweise ist es denkbar, das Gewicht magnetisch an dem Leiterplattensteckverbinder, mittels leicht zu zerstörender Rastverbindungen oder mittels Clipverbindungen von unzureichender Beständigkeit zu befestigen. Wird eine reversible Verbindung zwischen einem Leiterplattensteckverbinder und einem Gewicht zerstört, ist entscheidend, dass der Leiterplattensteckverbinder nicht beschädigt wird.

Es versteht sich, dass Verbindungen zwischen einem Leiterplattensteckverbinder und einem Gewicht eigens zur vorübergehenden Befestigung und zur leichten Zerstörung nach dem Beenden des Montageprozesses ausgebildet sein können. Sofern durch das Lösen derartiger leicht zu zerstörender Verbindungen lediglich die Verbindung und nicht der Leiterplattensteckverbinder beschädigt wird, spricht man dennoch von einer reversiblen Verbindung.

Gemäß einer bevorzugten Weiterbildung der Erfindung liegt das Gewicht an wenigstens zwei Auflageflächen und/oder an wenigstens zwei Berührflächen an der Leiterplatte an, wobei die Auflageflächen und/oder die Berührflächen symmetrisch gegenüber einer Symmetrieachse des Leiterplattensteckverbinders angeordnet sein können. Somit sind modulare Eigenschaften des Gewichts, die eine hohe Flexibilität für verschiedene Kombinationen aus einer Leiterplatte und einem Leiterplattensteckverbinder gewährleisten, möglich, indem die Auflageflächen bzw. Berührflächen abhängig von der Lage der Leiterplatte bezüglich des Leiterplattensteckverbinders dimensioniert und angeordnet werden.

Es versteht sich, dass ein Gewicht, welches zur Montage in einer Leiterplattenanordnung, wie sie vorstehend beschrieben wurde, vorteilhaft ist.

Ferner versteht es sich, dass auch ein Set aus einem Leiterplattensteckverbinder und einem Gewicht, vorteilhaft ist, wenn der Leiterplattensteckverbinder und das Gewicht eingerichtet sind, im Rahmen einer Vormontage zu einem Verbund aneinander montiert zu werden, um nach einer Endmontage des Verbunds aus Gewicht und Leiterplattensteckverbinder an einer Leiterplatte in einer Endmontage montiert zu werden, um eine Leiterplattenanordnung wie sie vorstehend beschrieben wurde, zu bilden.

Es versteht sich, dass auch ein Montageverfahren für ein solches Set vorteilhaft ist, wenn es die folgenden Schritte aufweist: Bereitstellen eines Leiterplattensteckverbinders und eines Gewichts; Befestigen des Gewichts an dem Leiterplattensteckverbinder, insbesondere mittels Clinchens, um einen Verbund aus einem Leiterplattensteckverbinder und einem Gewicht zu erhalten.

Dabei ist es auch vorteilhaft, wenn eine Leiterplattenanordnung montiert wird, indem ein Verbund wie er vorstehend beschrieben wurde, bereitgestellt wird und der Verbund an der Leiterplatte derart montiert wird, dass ein Strompfad von der Leiterplatte in den Leiterplattensteckverbinder verläuft, wobei die Lage des Schwerpunkts des Verbunds aus Gewicht und Leiterplattensteckverbinder derart liegt, dass ein Verkippen des Verbunds während der Montage des Verbunds auf der Leiterplatte verhindert wird.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: eine schematische Explosionsansicht einer Leiterplattenanordnung gemäß einer Ausführungsform der Erfindung;
- Figur 2: eine schematische Perspektivansicht einer Leiterplattenanordnung gemäß einer Ausführungsform der Erfindung;
- Figur 3: eine schematische Schnittsicht einer Leiterplattenanordnung gemäß einer Ausführungsform der Erfindung;
- Figur 4: eine schematische Schnittsicht eines Verbunds gemäß einer Ausführungsform der Erfindung.

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

Im Folgenden werden die Figuren zusammenhängend und übergreifend beschrieben.

### BESCHREIBUNG VON AUSFÜHRUNGSBEISPIELEN

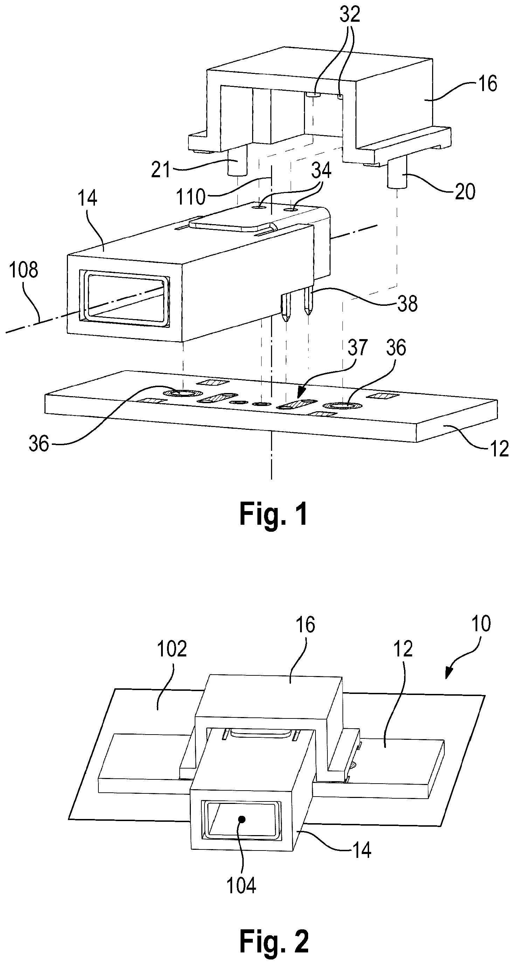

Figur 1 zeigt eine Leiterplattenanordnung 10 in einer Explosionsansicht. Die Leiterplattenanordnung 10 umfasst eine Leiterplatte 12, einen Leiterplattensteckverbinder 14 und ein Gewicht 16.

Aus Figur 1 geht die Lage, in welcher der Leiterplattensteckverbinder 14 und das Gewicht 16 gegenüber der Leiterplatte 12 montiert werden, hervor. Der Leiterplattensteckverbinder 14 und das Gewicht 16 weisen jeweils Verbindungsmittel zur Befestigung des Gewichts 16 an dem Leiterplattensteckverbinder 14 auf. Hierfür weist das Gewicht 16 Pins 32, die in Bohrungen 34 des Leiterplattensteckverbinders 14 eingepresst werden, auf. Ferner weist das Gewicht 16 Pins, die als Kodiermittel 20, 21 ausgebildet sind, auf, die in die Leiterplatte 12 in Bohrungen 36 eingepresst werden, auf. Der Leiterplattensteckverbinder 14 weist ein Paar von elektrischen Kontakten 38 auf, die in Bohrungen 37 der Leiterplatte 12 eingesetzt sind und eine Leiterbahn im Inneren der Leiterplatte elektrisch kontaktieren auf.

In Figur 1 ist ersichtlich, dass der Leiterplattensteckverbinder 14 für sich genommen gegenüber der Leiterplatte 12 einen ungünstigen Schwerpunkt aufweist, wenn der Leiterplattensteckverbinder 14 an der Leiterplatte 12 montiert ist, also dass ein in eine Leiterplattenebene projizierter Schwerpunkt des Leiterplattensteckverbinders 14 sich deutlich außerhalb der Leiterplatte 12 befindet.

Um ein Verkippen des Leiterplattensteckverbinders 14 auf der Leiterplatte zu verhindern, wird an dem Leiterplattensteckverbinder 14 das Gewicht 16 befestigt, bevor der Leiterplattensteckverbinder 14 auf der Leiterplatte 12 montiert wird. Dabei kann vorgesehen sein, dass das Gewicht 16 eine höhere Dichte aufweist, als der Leiterplattensteckverbinder 14, um den Schwerpunkt des Verbunds aus dem Gewicht 16 und dem Leiterplattensteckverbinder 14 gegenüber dem Schwerpunkt des Leiterplattensteckverbinders 14 in ausreichendem Maße zu verschieben.

Figur 2 zeigt eine perspektivische Ansicht einer Leiterplattenanordnung mit einer Leiterplatte 12, einem Leiterplattensteckverbinder 14 und einem Gewicht 16. Der projizierte Schwerpunkt 106 des Verbunds 11 befindet sich innerhalb der Leiterplatte 12, wohingegen sich der projizierte Schwerpunkt 104 das Leiterplattensteckverbinders 14 deutlich außerhalb der Leiterplatte 12 befindet.

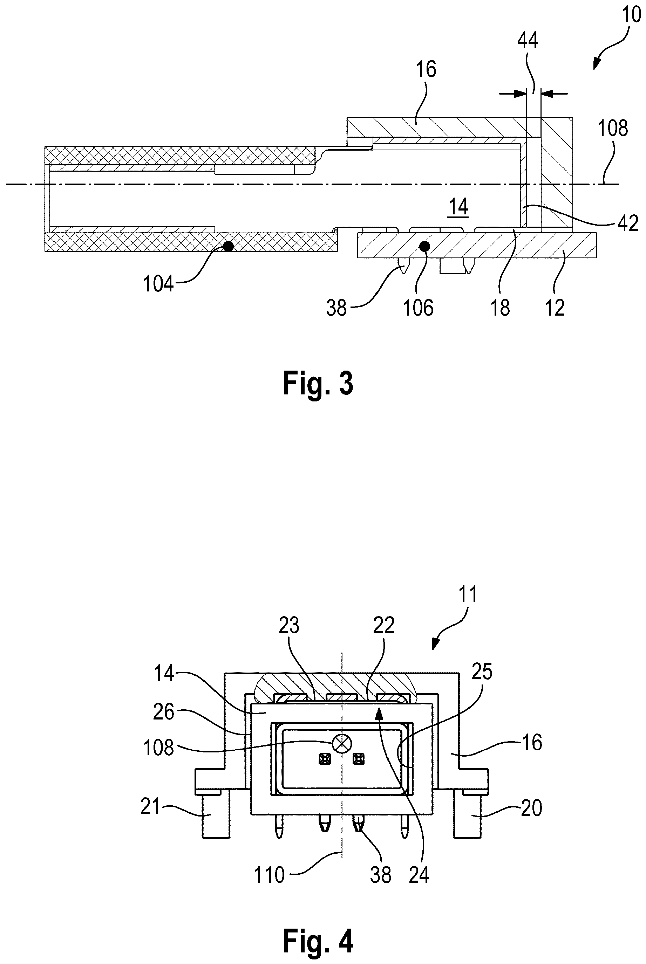

Figur 3 zeigt eine schematische Längsschnittsicht einer Leiterplattenanordnung 10. In Figur 3 ist die Lage des projizierten Schwerpunkts 104 des Leiterplattensteckverbinders 14 und des projizierten Schwerpunkts 106 des Verbunds 11 ersichtlich. Ferner ist ersichtlich, dass zwischen der Leiterplatte 12 und dem Leiterplattensteckverbinder 14 ein partieller Spalt 18 existiert. Der Spalt 18 erstreckt sich über den gesamten Bereich zwischen dem Leiterplattensteckverbinder 14 und der Leiterplatte 12, ausgenommen die elektrischen Kontakte 38.

Des Weiteren ist auch ein stirnseitiges Ende 42 des Leiterplattensteckverbinders 14 von einer gegenüberliegenden Kante des Gewichts 16 beanstandet. Dieser Abstand 44 bewirkt eine größere Verlagerung des projizierten Schwerpunkts 106 gegenüber dem projizierten Schwerpunkt 104, da sich hierdurch der Hebel, der von dem Gewicht auf den Leiterplattensteckverbinder wirkt, erhöht.

Es versteht sich, dass ein derartiger Abstand 44 in Abhängigkeit einer erforderlichen Verschiebung des projizierten Schwerpunkts 106 gegenüber dem projizierten Schwerpunkt 104 und in Abhängigkeit eines zur Verfügung stehenden Bauraums bemessen sein kann.

Figur 4 zeigt eine Querschnittsicht eines Verbunds 11 aus einem Leiterplattensteckverbinder 14 und einem Gewicht 16. In Figur 4 sind eine horizontale Symmetrieachse 110 und eine Längssymmetrieachse 108 dargestellt. Der Leiterplattensteckverbinder 14 ist an Auflageflächen 22, 23 und Berührflächen 25, 26 des Gewichts, die den Leiterplattensteckverbinder, an dessen Oberfläche 24 berühren, befestigt. Die Auflage- und Berührflächen 22, 23, 25, 26 sind symmetrisch bezüglich der Symmetrieachsen 108 und 110 angeordnet.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

### Bezugszeichenliste

- 10: Steckverbinderanordnung
- 11: Verbund
- 12: Leiterplatte
- 14: Leiterplattensteckverbinder
- 16: Gewicht
- 18: Spalt
- 20: Kodiermittel
- 21: Kodiermittel
- 22: Auflagefläche
- 23: Auflagefläche
- 24: Oberfläche
- 25: Berührfläche
- 26: Berührfläche
- 32: Pin
- 34: Bohrung
- 37: Bohrung
- 38: elektrische Kontakte
- 42: stirnseitiges Ende
- 44: Abstand
- 102: Leiterplattenebene
- 104: projizierter Schwerpunkt
- 106: projizierter Schwerpunkt
- 108: Symmetrieachse
- 110: Symmetrieachse

## Patentansprüche

1. Leiterplattenanordnung (10)
mit einer Leiterplatte (12), einem Leiterplattensteckverbinder (14), der auf der Leiterplatte vormontiert oder montiert ist und mit einem Gewicht (16), welches zumindest an dem Leiterplattensteckverbinder (14) angebracht ist,
wobei der Leiterplattensteckverbinder (14) für sich genommen bzgl. der Leiterplatte einen in die Leiterplattenebene (102) projizierten Schwerpunkt (104) aufweist, welcher sich außerhalb der Leiterplatte (12) befindet, und
wobei ein Verbund (11) aus dem Leiterplattensteckverbinder (14) und dem Gewicht (16) einen in die Leiterplattenebene (102) projizierten Schwerpunkt (106) aufweist, welche zu der Leiterplatte (12) einen geringeren Abstand oder keinen Abstand aufweist als der projizierte Schwerpunkt (104) des Leiterplattensteckverbinders (14) .

2. Leiterplattenanordnung nach Anspruch 1,
wobei das Gewicht (16) die Leiterplatte (12) berührt und insbesondere an der Leiterplatte (12) befestigt ist.

3. Leiterplattenanordnung nach einem der vorstehenden Ansprüche,
wobei das Gewicht (16) derart von der Leiterplatte (12) abgestützt ist, dass zwischen der Leiterplatte (12) und dem Leiterplattensteckverbinder (14) ein Spalt (18) existiert.

4. Leiterplattenanordnung nach einem der vorstehenden Ansprüche,
wobei das Gewicht (16) ein Kodiermittel (20, 21) zum Vorgeben einer oder mehrerer Montagepositionen und/oder Orientierungen des Leiterplattensteckverbinders (14) auf der Leiterplatte (12) aufweist.

5. Leiterplattenanordnung nach einem der vorstehenden Ansprüche,
wobei das Gewicht (16) lediglich passive elektrische Funktionalitäten oder keine elektrische Funktionalität der Leiterplattenanordnung (10) gewährleistet.

6. Leiterplattenanordnung nach einem der vorstehenden Ansprüche,
wobei einander berührende Komponenten (22-26) des Leiterplattensteckverbinders und des Gewichts mittels verschiedenen Fertigungsverfahren hergestellt sind, wobei insbesondere eine Komponente des Leiterplattensteckverbinders (14), die das Gewicht berührt, mittels eines Stanz-Biege-Verfahrens hergestellt ist und das Gewicht (16) mittels eines Gussverfahrens hergestellt ist.

7. Leiterplattenanordnung nach einem der vorstehenden Ansprüche,
wobei der Leiterplattensteckverbinder (14) irreversibel mit dem Gewicht (16) verbunden ist.

8. Leiterplattenanordnung nach einem der vorstehenden Ansprüche,
wobei das Gewicht (16) wenigstens zwei Auflageflächen (22, 23) und/oder wenigstens zwei Berührflächen (25, 26), an welchen das Gewicht (16) die Leiterplatte (12) berührt, wobei die Auflageflächen und/oder die Berührflächen, insbesondere symmetrisch gegenüber einer Symmetrieachse (108; 110) des Leiterplattensteckverbinders angeordnet sind.

9. Gewicht, welches zur Montage in einer Leiterplattenanordnung (10) nach einem der vorstehenden Ansprüche bestimmt ist.

10. Set aus einem Leiterplattensteckverbinder (14) und einem Gewicht (16), wobei der Leiterplattensteckverbinder und das Gewicht eingerichtet sind, im Rahmen einer Vormontage zu einem Verbund (11) aneinander montiert zu werden, um nach einer Endmontage an einer Leiterplatte (12), montiert zu werden, um eine Leiterplattenanordnung (10) nach einem der vorstehenden Ansprüche zu bilden.

11. Montageverfahren für ein Set nach Anspruch 10 mit den folgenden Schritten:
- Bereitstellen eines Leiterplattensteckverbinders (14) und eines Gewichts (16);
- Befestigen des Gewichts (16) an dem Leiterplattensteckverbinder (14), insbesondere mittels Clinchens, um einen Verbund (11) aus einem Leiterplattensteckverbinder und einem Gewicht (16) zu erhalten.

12. Montageverfahren für eine Leiterplattenanordnung nach einem der vorstehenden Ansprüche 1-8 mit den folgenden Schritten:
- Durchführen des Verfahrens nach Anspruch 11;
- Montieren des Verbunds (11) an der Leiterplatte (12) derart, dass ein Strompfad von der Leiterplatte in den Leiterplattensteckverbinder (14) verläuft, wobei die Lage des projizierten Schwerpunkts (106) des Verbunds derart liegt, dass ein Verkippen des Verbunds (11) während der Montage des Verbunds auf der Leiterplatte (12) verhindert wird.
